# EUROPÄISCHE PATENTSCHRIFT

(11) **EP 4 379 794 B1**
(45) Veröffentlichungstag und Bekanntmachung des Hinweises auf die Patenterteilung: **29.01.2025**
(21) Anmeldenummer: 22210750.0
(22) Anmeldetag: 01.12.2022
(51) Int. Cl.: H01L 23/427, B33Y 80/00

(54) **STÜTZVORRICHTUNG MIT PULSIERENDEM WÄRMEROHR, LEISTUNGSMODUL UND COMPUTERPROGRAMMPRODUKT**
PULSATING HEAT PIPE SUPPORT DEVICE, POWER MODULE, AND COMPUTER PROGRAM PRODUCT
DISPOSITIF DE SUPPORT À CALODUC PULSÉ, MODULE DE PUISSANCE ET PRODUIT DE PROGRAMME INFORMATIQUE

(43) Veröffentlichungstag der Anmeldung: 05.06.2024
(73) Patentinhaber: Siemens Aktiengesellschaft, 80333 München (DE)
(72) Erfinder: Danov, Vladimir, 91056 Erlangen (DE); Müller, Volker, 90459 Nürnberg (DE); Neugebauer, Stephan, 91058 Erlangen (DE); Schwarz, Florian, 90766 Fürth (DE); Stegmeier, Stefan, 81825 München (DE)
(74) Vertreter: Siemens Patent Attorneys

(56) Entgegenhaltungen:
- WO-A1-2021/163312
- DE-A1- 102017 005 568
- DE-A1- 102021 109 270
- US-A1- 2017 286 572
- US-A1- 2022 151 116

## Beschreibung

Die Erfindung betrifft eine Stützvorrichtung für ein elektrisch leitendes Verbindungselement und ein Leistungsmodul, das über eine solche Stützvorrichtung verfügt. Die Erfindung betrifft ebenso ein Computerprogrammprodukt zum Simulieren eines Betriebsverhaltens einer derartigen Stützvorrichtung.

Die Deutsche Patentanmeldung DE102017005568 offenbart eine Stützvorrichtung zum mechanischen Abstützen eines elektrisch leitenden zu entwärmenden Verbindungselements auf einer Wärmesenke, die das Verbindungselement von der Wärmesenke elektrisch isoliert. Aus der Internationalen Anmeldung mit dem Aktenzeichen PCT/EP2022/075791, veröffentlicht als WO 2023/052151 A1, ist eine thermisch leitfähige Halterung bekannt, in der Kanäle ausgebildet sind, die als Heatpipes dienen können. Die Kanäle erstrecken sich im Wesentlichen entlang einer Zylindermantelfläche in einem Kunststoffkörper und sind an Stirnseiten der Halterung durch Metallelemente verschlossen.

Die Europäische Patentanmeldung EP 3 336 471 A1 offenbart ein Elektroniksubstrat, das zu kühlen ist. Das Elektroniksubstrat ist von Kanälen durchzogen, die in einer Substratebene liegen. Die Kanäle bilden eine Schleife und dienen als ein pulsierendes Wärmerohr, auch pulsierende Heatpipe genannt.

Die Patentschrift US 6,672,373 B2 beschreibt ein pulsierendes Wärmerohr, das abschnittsweise unterschiedliche Durchmesser und Krümmungsradien aufweist. Das pulsierende Wärmerohr ist ferner mit Ausgleichsgefäßen für sein Fluid versehen.

Leistungselektrische Schaltungen mit steigenden elektrischen Leistungen werden in einer Vielzahl an Anwendungen eingesetzt. Dementsprechend werden gesteigerte Anforderungen an eine Entwärmung derartiger Schaltungen gestellt. Gleichzeitig besteht die Zielsetzung, die Entwärmung von leistungselektrischen Schaltungen kosteneffizient und prozesssicher herzustellen. Ebenso wird ein verschleißarmer Betrieb angestrebt. Dies gilt insbesondere für die Entwärmung elektrisch leitender Verbindungselemente solcher leistungselektrischer Schaltungen, beispielsweise von deren Stromschienen. Der Erfindung liegt die Aufgabenstellung zugrunde, eine Möglichkeit zur Entwärmung einer leistungselektrischen Schaltung bereitzustellen, die in zumindest einem der oben skizzierten Aspekte eine Verbesserung bietet.

Die Aufgabenstellung wird durch eine erfindungsgemäße Stützvorrichtung gelöst, die dazu geeignet ist, ein elektrisch leitendes Verbindungselement, das zu entwärmen ist, mechanisch abzustützen. Das mechanische Abstützen kann hierbei ein punktweises Abstützen sein. Das elektrisch leitende Verbindungselement kann beispielsweise als Stromschiene ausgebildet sein. Das elektrisch leitende Verbindungselement, im Folgen auch nur als Verbindungselement bezeichnet, gehört zu einer leistungselektrischen Schaltung, beispielsweise einem Leistungsmodul, und wird durch die Stützvorrichtung mechanisch auf einer Wärmesenke abgestützt, in die Wärme aus dem Verbindungselement abzuführen ist. Das Verbindungselement wird durch die Stützvorrichtung von der Wärmesenke elektrisch isoliert. Hierzu kann die Stützvorrichtung beispielsweise zumindest teilweise aus einem Kunststoff hergestellt sein. Erfindungsgemäß ist in der Stützvorrichtung zumindest ein pulsierendes Wärmerohr ausgebildet, durch das Wärme vom Verbindungselement zur Wärmesenke transportierbar ist. Derartige pulsierende Wärmerohre werden auch mit dem englischen Fachbegriff als pulsating heatpipes bezeichnet. In der vorliegenden Anmeldung werden die pulsierenden Wärmerohre auch verkürzt als Wärmerohre bezeichnet. Das zumindest eine pulsierende Wärmerohr kann als geschlossener Kreislauf ausgebildet sein oder als pulsierendes Wärmerohr mit zwei Enden. Dabei kann das pulsierende Wärmerohr eine Schlaufe ausbilden. Das zumindest eine pulsierende Wärmerohr ist zu einem Wärmetransport vom verbindungselementseitigen Ende zum wärmesenkeseitigen Ende der Stützvorrichtung ausgebildet. Folglich dient das pulsierende Wärmerohr in der Stützvorrichtung somit zur Entwärmung des Verbindungselements in die Wärmesenke. Die Wärmesenke kann hierbei als Kühlkörper, als Gehäusekomponente oder als eine Komponente einer anderen leistungselektrischen Schaltung ausgebildet sein.

Durch das pulsierende Wärmerohr wird eine leistungsfähige Entwärmung bereitgestellt, die selbsttätig, also ungesteuert, betreibbar ist und miniaturisierbar ist. Das pulsierende Wärmerohr ist weiter geometrisch anpassbar und somit in eine Vielzahl an unterschiedlichen Typen von Stützvorrichtungen integrierbar. Ferner kann die Stützvorrichtung zumindest teilweise aus elektrisch isolierendem Kunststoff hergestellt sein, der eine reduzierte Wärmeleitfähigkeit aufweist. Die Verwendung kostenintensiver Werkstoffe, die elektrisch isolierend sind und gleichzeitig eine erhöhte Wärmeleitfähigkeit aufweisen, wird bei der erfindungsgemäßen Stützvorrichtung minimiert. Die Stützvorrichtung kann zumindest teilweise aus einem Kunststoff hergestellt sein, der einfach zu bearbeiten ist, was wiederum eine schnelle, einfache und gleichzeitig präzise Herstellung des zumindest einen pulsierenden Wärmerohrs erlaubt.

In der erfindungsgemäßen Stützvorrichtung ist das zumindest eine pulsierende Wärmerohr zumindest teilweise mit einer diffusionshemmenden Beschichtung versehen. Die diffusionshemmende Beschichtung kann als metallische Beschichtung oder keramische oder glasartige Beschichtung ausgebildet sein. Die diffusionshemmende Beschichtung ist dazu ausgebildet, das Eintreten von Flüssigkeiten, beispielsweise Wasserdampf, oder Gasen aus der Umgebungsluft in das pulsierende Wärmerohr zu vermeiden. Dadurch ist eine Verunreinigung des Fluids im pulsierenden Wärmerohr reduzierbar oder vermeidbar. Im zumindest einen pulsierenden Wärmerohr kann gegenüber der Umgebungsluft ein Unterdruck vorliegen, der durch eine Verunreinigung verändert werden kann. Derartige pulsierende Wärmerohre sind mit einer entsprechenden Beschichtung dauerhaft zuverlässig betreibbar. Hierdurch wird insgesamt eine gesteigerte Lebensdauer der beanspruchten Stützvorrichtung gewährleistet.

In einer Ausführungsform der beanspruchten Stützvorrichtung ist diese in einem mittleren Bereich aus einem ersten Werkstoff hergestellt, der eine erste Wärmeleitfähigkeit aufweist. Weiter ist die Stützvorrichtung an einem verbindungselementseitigen Ende und/oder einem wärmesenkeseitigen Ende aus einem zweiten Werkstoff hergestellt, der eine zweite Wärmeleitfähigkeit aufweist. Der mittlere Bereich ist hierbei als ein Abschnitt der Stützvorrichtung zwischen dem verbindungselementseitigen Ende und dem wärmesenkeseitigen Ende zu verstehen. Im mittleren Bereich können thermische Randeffekte, die am verbindungselementseitigen Ende und/oder am wärmesenkeseitigen Ende vorliegen, minimiert sein. Des Weiteren kann die zweite Wärmeleitfähigkeit höher sein als die erste Wärmeleitfähigkeit. Dadurch wird eine verbesserte thermische Ankopplung der Stützvorrichtung an das Verbindungselement und/oder die Wärmesenke erreicht werden. Der erste und zweite Werkstoff können jeweils als Kunststoff ausgebildet sein, in dem eine vorgebbare Konzentration an wärmeleitenden Partikeln und/oder Fasern vorliegt. Die wärmeleitenden Partikel können beispielsweise durch ein additives Fertigungsverfahren dem Kunststoff zugefügt werden. Die Partikel bzw. Fasern können zumindest teilweise aus Glas, Keramik, einem metallischen Werkstoff, oder Kohlenstoff hergestellt sein. Weiter können die Partikel und/oder Fasern derart in der entsprechenden Komponente der Stützvorrichtung aufgenommen sein, dass diese höchstens das wärmesenkeseitige Ende oder das verbindungselementseitige Ende elektrisch leitend kontaktiert. Der mittlere Bereich und das verbindungselementseitige bzw. wärmesenkeseitige Ende aus dem ersten bzw. zweiten Werkstoff können als separate Komponenten der Stützvorrichtung ausgebildet sein oder einstückig ausgebildet sein. Weiter können der mittlere Bereich, das verbindungselementseitige Ende und/oder das wärmesenkeseitige Ende durch Spritzgießen hergestellt sein. Zwischen dem ersten und zweiten Werkstoff kann eine im Wesentlichen diskrete Grenze vorliegen oder ein vorgebbarer Übergang. Sowohl die diskrete Grenze also auch der vorgebbare Übergang können beispielsweise durch ein additives Fertigungsverfahren hergestellt sein. Alternativ oder ergänzend kann am vorgebbaren Übergang auch durch eine Klebverbindung oder eine Schweißverbindung vorliegen. Ferner kann am vorgebbaren Übergang auch ein Dichtelement angeordnet sein. Wenn der mittlere Bereich und das verbindungselementseitige Ende bzw. der wärmesenkeseitige Ende als separate Komponenten ausgebildet sind, die Stützvorrichtung also in Differentialbauweise ausgebildet ist, können diese jeweils vollständig aus dem ersten bzw. zweiten Werkstoff hergestellt sein.

Darüber hinaus kann am verbindungselementseitigen Ende und/oder am wärmesenkeseitigen Ende der beanspruchten Stützvorrichtung ein Montagefuß ausgebildet sein. Der Montagefuß kann am verbindungselementseitigen Ende bzw. dem wärmesenkeseitigen Ende angeformt sein und im Wesentlichen flächig ausgebildet sein. Das zumindest eine pulsierende Wärmerohr erstreckt sich zumindest teilweise durch den Montagefuß. Durch den Montagefuß wird am Verbindungselement und/oder an der Wärmesenke eine vergrößerte Fläche zur Wärmeankopplung des Stützelements bereitgestellt.

In einer weiteren Ausführungsform der beanspruchten Stützvorrichtung ist zumindest ein pulsierendes Wärmerohr zumindest teilweise mit einem elektrisch leitenden Fluid gefüllt. Das elektrisch leitende Fluid kann beispielsweise Wasser oder eine wässrige Lösung sein. Durch die beanspruchte Stützvorrichtung ist das Verbindungselement von der Wärmesenke elektrisch isoliert, so dass durch die Verwendung eines elektrisch leitfähigen Fluids keine Gefahr besteht, dass die Wärmesenke unter elektrische Spannung gesetzt wird. Die Verwendung elektrisch isolierender Fluide oder solche mit vernachlässigbarer elektr. Leitfähigkeit < 100 µS/cm, insbesondere <10 µS/cm, ist in der beanspruchten Stützvorrichtung entbehrlich. Dementsprechend steht ein verbreitertes Spektrum an Fluiden zur Verfügung, durch die die Wärmetransporteigenschaften des pulsierenden Wärmerohrs genauer vorgebbar sind. Insbesondere können als Fluid Wasser, Ethanol, Kühlmittel, ein Ferrofluid, ein Elektrofluid, oder ein dielektrisches Fluid, beispielsweise Perfluoro(2-methyl-3-pantatone) eingesetzt werden. Das Fluid kann mit Metallpartikeln versetzt sein, durch die eine vorliegende Entwärmungsleistung des zumindest einen pulsierenden Wärmerohrs messbar ist. Die beanspruchte Stützvorrichtung ist insgesamt kosteneffizient herstellbar und für ein breites Einsatzspektrum anforderungsgerecht anpassbar.

Des Weiteren kann die beanspruchte Stützvorrichtung einstückig ausgebildet sein. Die Stützvorrichtung kann hierzu im Wesentlichen vollständig durch additive Fertigung, beispielsweise 3D-Druck, hergestellt sein. Durch additive Fertigung ist bei gleichbleibendem Bauraum eine größere Anzahl an pulsierenden Wärmerohren und reduzierte lichte Durchmesser und/oder verringerte Krümmungsradien des zumindest einen pulsierenden Wärmerohrs herstellbar. Dadurch ist das zumindest eine pulsierende Wärmerohr dazu geeignet, auch an filigranen Abschnitten der Stützvorrichtung eine Entwärmung durchzuführen. Infolgedessen ist eine gesteigerte Entwärmungsleistung erzielbar. Alternativ kann die beanspruchte Stützvorrichtung einen Kernabschnitt und einen Glockenabschnitt umfassen. Der Glockenabschnitt kann bei einer Montage über den Kernabschnitt gestülpt werden. Das zumindest eine pulsierende Wärmerohr kann aus Ausnehmung oder Kombination von Ausnehmungen am Kernabschnitt und/oder am Glockenabschnitt ausgebildet sein. Die Ausnehmung bzw. die Kombination an Ausnehmungen kann jeweils dadurch hergestellt werden, indem der Kernabschnitt und/oder der Glockenabschnitt jeweils durch Spritzgießen oder massivumformend hergestellt werden oder spanend bearbeitet sind. Der Kernabschnitt und der Glockenabschnitt sind jeweils schnell und einfach herstellbar, wodurch die beanspruchte Stützvorrichtung wiederum kosteneffizient herstellbar ist. Durch den Glockenabschnitt kann ferner das verbindungselementseitige Ende oder das wärmesenkeseitige Ende der Stützvorrichtung ausgebildet werden. Wenn Kontaktflächen am verbindungselementseitigen Ende und am wärmesenkeseitigen Ende nicht parallel sind, kann der Glockenabschnitt sowohl das wärmesenkeseitige und das verbindungselementseitige Ende der Stützvorrichtung umfassen. Insbesondere kann der Kernabschnitt aus dem ersten Werkstoff mit der ersten Wärmeleitfähigkeit hergestellt sein und der Glockenabschnitt aus dem zweiten Werkstoff mit der zweiten Wärmeleitfähigkeit. Alternativ können der Kernabschnitt und/oder der Glockenabschnitt auch abschnittsweise aus dem ersten bzw. zweiten Werkstoff hergestellt sein. Das Wärmetransportverhalten des zumindest einen pulsierenden Wärmerohrs ist folglich durch die Konstruktion des Kernabschnitts und des Glockenabschnitts weiter einstellbar. Darüber hinaus können der Glockenabschnitt und der Kernabschnitt auch konisch ausgebildet sein, insbesondere eine Formschräge aufweisen, wodurch eine gegenseitige Passung verbessert wird. Insbesondere sind so Spalte zwischen mehreren benachbarten pulsierenden Wärmerohren in einfacher Weise vermeidbar. Der Glockenabschnitt und/oder der Kernabschnitt können unterschiedliche optische Transmissionseigenschaften aufweisen, wodurch diese beispielsweise mittels Laserstrahlschweißen miteinander verbindbar sind. Ebenso kann der Glockenabschnitt aus einem transparenten Werkstoff hergestellt sein, was eine einfache Sichtinspektion der Stützvorrichtung erlaubt.

Ferner kann in der beanspruchten Stützvorrichtung eine Mehrzahl an pulsierenden Wärmerohren im Bereich einer Umfangswandung ausgebildet sein, die zwischen dem verbindungselementseitigen Ende und dem wärmesenkeseitigen Ende liegt. Die Umfangswandung kann sich vom verbindungselementseitigen Ende zum wärmesenkeseitigen Ende erstrecken und diese verbinden. Durch die Umfangswandung ist eine Oberfläche der Stützvorrichtung im mittleren Bereich definiert. Die Umfangswandung kann im Wesentlichen als Zylindermantelfläche ausgebildet sein. Alternativ kann die Umfangswandung als jegliche umlaufende Mantelfläche ausgebildet sein. Die pulsierenden Wärmerohre können sich innerhalb der Stützvorrichtung im Bereich seiner Oberfläche befinden, wodurch eine Wärmeabgabe an Umgebungsluft erleichtert wird. Die pulsierenden Wärmerohre können sich insbesondere bis zu 5 mm unter einer Oberfläche der Umfangswandung im mittleren Bereich der Stützvorrichtung erstrecken. Dementsprechend ist eine vergrößerte Oberfläche für pulsierende Wärmerohre nutzbar, wodurch die Entwärmung des Verbindungselements weiter unterstützt wird. Dadurch, dass eine vergrößerte Oberfläche zur Verfügung steht, können die Ausnehmungen für die pulsierenden Wärmerohre mit einer erhöhten Fertigungstoleranz hergestellt werden, was wiederum eine vereinfachte Herstellung erlaubt. Ferner kann bei einer Stützvorrichtung, die einen Glockenabschnitt und einen Kernabschnitt aufweist, der Glockenabschnitt dünnwandig ausgebildet sein, was ebenso eine vereinfachte Herstellung ermöglicht, beispielsweise durch Spritzgießen.

In einer weiteren Ausführungsform der beanspruchten Stützvorrichtung kann die diffusionshemmende Beschichtung durch Gasphasenabscheidung, physikalische Dampfabscheidung, einen Sol-Gel-Prozess, thermisches Sprühen, durch Bedampfen, autokatalytisches Beschichten oder durch ein Galvanik-Verfahren hergestellt werden.

Darüber hinaus kann in der beanspruchten Stützvorrichtung deren Umfangswandung, deren verbindungselementseitiges Ende und/oder deren wärmesenkeseitiges Ende mit einer diffusionshemmenden Beschichtung versehen sein. Die diffusionshemmende Beschichtung kann als metallische, keramische oder glasartige Beschichtung ausgebildet sein. Im zumindest einen pulsierenden Wärmerohr kann gegenüber der Umgebungsluft ein Unterdruck vorliegen. Durch die diffusionshemmende Beschichtung ist das Eindringen von Flüssigkeit, beispielsweise Wasserdampf, oder Gasen aus der Umgebungsluft in die Stützvorrichtung reduzierbar oder vermeidbar. Die Beschichtung der Umfangswandung, des verbindungselementseitigen Endes und/oder des wärmesenkeseitigen Endes kann an deren Oberfläche ausgebildet sein oder in deren Inneren angeordnet sein. Eine Beschichtung an der Oberfläche ist in besonders einfacher Weise herstellbar. Eine Beschichtung, die im Inneren der Umfangswandung, des verbindungselementseitigen Endes und/oder des wärmesenkeseitigen Endes liegt, ist wiederum durch die jeweilige Komponente selbst geschützt. Hierdurch kann die Beschichtung aus einem Material ausgebildet sein, das gegen dauerhaften Kontakt mit der Umgebungsluft chemisch unbeständig ist. Durch die Vermeidung mechanischer Beanspruchungen kann die Beschichtung eine reduzierte Schichtdicke aufweisen. Derartige Beschichtungen können ferner mittels additiver Fertigung hergestellt sein. Weiter weist die beanspruchte Stützvorrichtung durch eine derartige Beschichtung eine gesteigerte Isolationsfestigkeit auf.

In der beanspruchten Stützvorrichtung kann das zumindest eine pulsierende Wärmerohr auch durch die Wärmesenke und/oder das zu entwärmende Verbindungselement verschlossen sein. Das zumindest eine pulsierende Wärmerohr kann als Durchgangsbohrung ausgebildet sein, die sich im Bereich der Umfangswandung durch den mittleren Bereich der Stützvorrichtung erstreckt. An Stirnflächen der Stützvorrichtung kann das zumindest eine pulsierende Wärmerohr als Ausnehmung fortgesetzt sein, also im Wesentlichen als offene Rinne, die durch das Verbindungselement bzw. die Wärmesenke im montierten Zustand verschlossen wird. In einer derartigen Stützvorrichtung wird im pulsierenden Wärmerohr ein elektrisch isolierendes Fluid verwendet. Eine entsprechende Stützvorrichtung weist eine reduzierte Anzahl an Komponenten auf und ist dadurch in besonders einfacher Weise herstellbar. Ferner ist derart ein direkterer wärmeleitender Kontakt zum Verbindungselement bzw. zur Wärmesenke herstellbar.

Ferner kann die beanspruchte Stützvorrichtung einen Sensor aufweisen, der dazu ausgebildet ist, zumindest eine physikalische Größe des pulsierenden Wärmerohrs und/oder einer Komponente der Stützvorrichtung zu erfassen. Beispielsweise kann der Sensor als Drucksensor oder Temperatursensor ausgebildet sein, durch den der Druck bzw. die Temperatur des Fluids im der pulsierenden Wärmerohr erfassbar ist. Der Druck bzw. die Temperatur des Fluids erlauben Rückschlüsse darauf, inwieweit eine Wärmetransportkapazität des pulsierenden Wärmerohrs zu einem Messzeitpunkt ausgenutzt wird. Ebenso kann der Sensor dazu ausgebildet sein, Vibrationen zu erfassen. Weiter kann der Sensor dazu ausgebildet sein, so genanntes Energy-Harvesting zu betreiben. Der Sensor kann dazu beispielsweise einen Thermogenerator oder eine Piezo-Membran aufweisen und/oder durch Induktion elektrische Energie für seinen Betrieb zu gewinnen. Der Sensor kann dadurch dauerhaft zuverlässig betrieben werden. Des Weiteren kann der Sensor über eine Kommunikationseinheit, insbesondere eine drahtlose Kommunikationseinheit, verfügen. Hierdurch ist der Zustand der Stützvorrichtung in einfacher Weise überwachbar. Basierend auf über den Sensor gewonnenen Daten kann eine Applikation, in der die Stützvorrichtung eingesetzt wird, beispielsweise ein Leistungsmodul, in puncto thermischer Beanspruchung optimiert betrieben werden. Ebenso können Störungen erfasst und eine verbleibende technisch nutzbare Lebensdauer der Stützvorrichtung abgeschätzt werden.

Des Weiteren kann die beanspruchte Stützvorrichtung am verbindungselementseitigen Ende und/oder am wärmesenkeseitigen Ende eine Ausnehmung aufweisen, durch die eine eingestülpte Fläche gebildet wird. Die Ausnehmung kann beispielsweise an einer Stirnfläche der Stützvorrichtung ausgebildet sein. Die eingestülpte Fläche dient zu einer Wärmeankopplung an das zu entwärmende Verbindungselement bzw. die Wärmesenke. Die Ausnehmung bildet im Bereich des verbindungselementseitigen bzw. wärmesenkeseitigen Endes eine vergrößerte Oberfläche aus, an der ein thermisch leitender Kontakt zum Verbindungselement bzw. der Wärmesenke herstellbar ist. Dadurch ist bauraumsparend eine verbesserte Wärmeankopplung erzielbar. Die beanspruchte Stützvorrichtung ist somit an solche Anwendungen mit erhöhter Miniaturisierung, insbesondere Leistungsmodule, anpassbar. Das zumindest eine Wärmerohr kann sich im Bereich der Ausnehmung, insbesondere einer Wandung, die die Ausnehmung begrenzt, erstrecken. Das pulsierende Wärmerohr kann im Bereich der Ausnehmung im Wesentlichen U-förmig ausgebildet sein. Durch die Ausnehmung wird auch eine Zentrierung für die Montage der Stützvorrichtung bereitgestellt. Insbesondere kann die Ausnehmung in einer Stirnfläche eines Kernabschnitts der Stützvorrichtung ausgebildet sein. Durch die Ausnehmung im Kernabschnitt wird der zugehörige Glockenabschnitt der Stützvorrichtung zentriert. Weiter kann in der Ausnehmung, die die eingestülpte Fläche zur Wärmeankopplung bildet, ein Einkopplungselement aufgenommen sein, das aus einem metallischen Werkstoff hergestellt ist. Das Einkopplungselement ist zu einer thermischen Verbindung zwischen dem Verbindungselement bzw. der Wärmesenke und der Stützvorrichtung über die eingestülpte Fläche ausgebildet. Weiter können die eingestülpte Fläche und/oder das Einkopplungselement konisch ausgebildet sein, wodurch eine einfache und präzise Herstellung gewährleistet ist. Darüber hinaus können die eingestülpte Fläche und/oder das Einkopplungselement zu einem gegenseitigen Verpressen ausgebildet sein, oder hinterschnitten ausgebildet sein, wodurch eine formschlüssige Verbindung ausgebildet sein kann. Ferner können die eingestülpte Fläche und das Einkopplungselement miteinander über eine Verklebung verbunden sein. Das Einkopplungselement kann als Buchse ausgebildet sein und/oder zum Herstellen einer lösbaren Verbindung mit dem Verbindungselement bzw. der Wärmesenke ausgebildet sein. Das Einkopplungselement kann hierzu beispielsweise mit einer Gewindebohrung versehen sein. Das Einkopplungselement ist im montierten Zustand minimierten Zug- und Schälbeanspruchungen ausgesetzt. Stattdessen ist das Einkopplungselement überwiegend Scherbeanspruchungen unterworfen. Hierdurch ist das Einkopplungselement einer bauteilgerechten mechanischen Beanspruchung unterworfen.

In einer weiteren Ausführungsform ist die beanspruchte Stützvorrichtung zumindest teilweise durch ein additives Fertigungsverfahren hergestellt. Die Stützvorrichtung kann dazu einstückig ausgebildet sein und abschnittsweise durch ein additives Fertigungsverfahren hergestellt sein, oder komponentenweise. Additive Fertigungsverfahren erlauben es, durch eine vorgebbare Mischung an Zusatzstoffen, beispielsweise wärmeleitende Partikel, die Stützvorrichtung mit lokal einstellbaren Eigenschaften, insbesondere Wärmeleiteigenschaften, herzustellen. Ferner sind durch additive Fertigungsverfahren filigrane bzw. geometrisch komplexe, z.B. verschachtelte pulsierende Wärmerohre einfach und kosteneffizient herstellbar. Dadurch sind die technischen Eigenschaften der eingesetzten Werkstoffe weiter ausschöpfbar. Dies wiederum erlaubt eine stärkere Miniaturisierung der beanspruchten Stützvorrichtung. Das additive Fertigungsverfahren kann beispielsweise 3D-Druck, pulverbettloses Druckverfahren, insbesondere Fused Deposition Modeling, Stereolithographie oder ein Jetting-Verfahren sein.

Die beschriebene Aufgabenstellung wird ebenso durch ein erfindungsgemäßes Leistungsmodul gelöst. Das Leistungsmodul kann beispielsweise zu einem sogenannten Power Module oder einem Umrichter gehören. Das Leistungsmodul umfasst ein Substrat, das mit mindestens einem elektrisch leitenden Verbindungselement, beispielsweise einer Stromschiene, versehen ist, das in einem aktiven Betriebszustand des Leistungsmoduls zu entwärmen ist. Das Verbindungselement ist im Leistungsmodul durch eine Stützvorrichtung abgestützt auf einer Wärmesenke, in die das Verbindungselement zu entwärmen ist. Erfindungsgemäß ist die Stützvorrichtung gemäß zumindest einer der oben skizzierten Ausführungsformen ausgebildet. Die Merkmale der beanspruchten Stützvorrichtung sind infolgedessen analog auf das erfindungsgemäße Leistungsmodul übertragbar. Das beanspruchte Leistungsmodul kann zusammen mit einer übergeordneten Steuereinheit zu einem System gehören, durch das die oben beschriebene Aufgabe ebenso gelöst wird. Das System ist dazu ausgebildet, den Betriebszustand des Leistungsmoduls zu überwachen. Hierzu weist zumindest eine Stützvorrichtung im Leistungsmodul einen Sensor auf, der mittelbar oder unmittelbar mit der übergeordneten Steuereinheit kommunikativ gekoppelt ist. Die übergeordnete Steuereinheit ist dazu ausgebildet, vom Sensor empfangene Daten auszuwerten und eine Warnung auszugeben. Die übergeordnete Steuereinheit kann in das Leistungsmodul integriert ausgebildet sein.

Ferner wird die zugrundeliegende Aufgabenstellung durch ein erfindungsgemäßes Computerprogrammprodukt gelöst, das zu einem Simulieren eines Betriebsverhaltens einer Stützvorrichtung ausgebildet ist. Das zu simulierende Betriebsverhalten kann während eines aktiven Betriebs eines Leistungsmoduls vorliegen, in dem die Stützvorrichtung angeordnet ist. Das Computerprogrammprodukt umfasst Befehle, die bei der Ausführung des Computerprogrammprodukts durch einen Computer diesen veranlassen, das Betriebsverhalten der Stützvorrichtung zu simulieren. Erfindungsgemäß ist die Stützvorrichtung gemäß einer der oben dargestellten Ausführungsformen ausgebildet. Die oben skizzierten Merkmale sind somit analog auch auf das erfindungsgemäße Computerprogrammprodukt übertragbar.

Das Computerprogrammprodukt kann zur Simulation über ein Physik-Modul verfügen, in dem die Stützvorrichtung zumindest teilweise abgebildet ist. Hierzu kann beispielsweise die Stützvorrichtung in ihrem Aufbau und ihrer Funktionsweise nachgebildet sein, beispielsweise als digitales Abbild, das zum Computerprogrammprodukt gehört. Alternativ oder ergänzend kann die Stützvorrichtung auch als Rechenmodell im Physik-Modul ausgebildet sein. Das Physik-Modul ist dazu ausgebildet, unter anderem das thermische Verhalten der Stützvorrichtung, das Fließverhalten, das Verdampfungsverhalten und/oder das Kondensationsverhalten des darin verwendeten Fluids unter einstellbaren Betriebsbedingungen nachzustellen. Zu den einstellbaren Betriebsbedingungen gehören beispielsweise eine Umgebungstemperatur, ein Druck des Fluids, dessen Temperatur, eine Wärmeleitfähigkeit des Fluids und/oder der einzelnen Komponenten der Stützvorrichtung, eine Temperatur des zu entwärmenden Verbindungselements, und/oder eine Temperatur der Wärmesenke gehören. Das Computerprogrammprodukt kann über eine Datenschnittstelle verfügen, über die entsprechende Daten über eine Benutzereingabe, eine Datenverbindung zu einer übergeordneten Steuereinheit eines realen Systems mit einem Leistungsmoduls mit einer entsprechenden Stützvorrichtung und/oder andere simulationsgerichtete Computerprogramme vorgebbar sind. Ebenso kann das Computerprogrammprodukt über eine Datenschnittstelle zu einem Ausgeben von Simulationsresultaten an einen Benutzer und/oder andere simulationsgerichtete Computerprogrammprodukte verfügen. Mittels des Computerprogrammprodukts ist beispielsweise eine defekte Stützvorrichtung, eine fehlerhafte Verbindung zwischen der Stützvorrichtung und der Wärmesenke bzw. dem Verbindungselement und/oder eine Undichtigkeit an zumindest einem pulsierenden Wärmerohr erkennbar. Insbesondere ist das Betriebsverhalten der realen Stützvorrichtung, ausgedrückt beispielsweise durch Messwerte eines darin aufgenommenen Sensors, oder Sensoren im Leistungsmodul, durch Abgleich mit der simulierten Stützvorrichtung auf Plausibilität überprüfbar. Beispielsweise ist das Betriebsverhalten eines pulsierenden Wärmerohrs realitätstreu simulierbar. Das zumindest eine pulsierende Wärmerohr kann als zweidimensionales Modell im beanspruchten Computerprogrammprodukt nachgestellt sein. Pulsierende Wärmerohre sind mit hoher Realitätstreue mit minimiertem Rechenaufwand simulierbar. Die Stützvorrichtung ist folglich in einfacher Weise modellierbar, also mit einem Minimum an sogenannten CFD-Berechnungen im Betriebsverhalten nachrechenbar. Insbesondere kann das Wärmetransportverhalten im pulsierenden Wärmerohr mit hinreichender Präzision durch algebraische Berechnung approximiert werden. Das erfindungsgemäße Computerprogrammprodukt erlaubt somit eine Modellierung der zugrundeliegenden Stützvorrichtung bei einem reduzierten Bedarf an Rechenleistung. Hierdurch ist auch eine Vielzahl an derartigen Stützvorrichtungen, beispielsweise in einem Leistungsmodul nachbildbar. Somit ist insgesamt in einfacher Weise ein besonders realitätstreues Prozessabbild vom Betrieb einer entsprechenden Applikation bereitstellbar. Ebenso kann durch das beanspruchte Computerprogrammprodukt infolge des reduzierten Rechenaufwands in einfacher Weise Echtzeitfähigkeit erreicht werden, was wiederum eine leistungsfähige Überwachung einer entsprechenden Stützvorrichtung bzw. eines entsprechenden Leistungsmoduls erlaubt. Das Computerprogrammprodukt kann als sogenannter Digitaler Zwilling ausgebildet sein, wie beispielsweise in der Druckschrift US 2017/286572 A1 beschrieben. Dementsprechend ist der Digitale Zwilling korrespondierend zur Stützvorrichtung nach einer der oben skizzierten Ausführungsformen ausgebildet. Das Computerprogrammprodukt kann monolithisch ausgebildet sein, also vollständig auf einer Hardwareplattform ausführbar. Alternativ kann das Computerprogrammprodukt modular ausgebildet sei und eine Mehrzahl an Teilprogrammen umfassen, die auf separaten Hardwareplattformen ausführbar sind und über eine kommunikative Datenverbindung zusammenwirken. Eine solche kommunikative Datenverbindung kann eine Netzwerkverbindung, eine Internetverbindung und/oder eine Mobilfunkverbindung sein. Ferner kann durch das erfindungsgemäße Computerprogrammprodukt eine Stützvorrichtung per Simulation erprobt und/oder optimiert werden.

Die Erfindung wird im Folgenden anhand einzelner Ausführungsformen in Figuren näher erläutert. Die Figuren sind insoweit in gegenseitiger Ergänzung zu lesen, dass gleiche Bezugszeichen in unterschiedlichen Figuren die gleiche technische Bedeutung haben. Die Merkmale der einzelnen Ausführungsformen sind untereinander auch kombinierbar. Ferner sind die in den Figuren gezeigten Ausführungsformen mit den oben skizzierten Merkmalen kombinierbar. Es zeigen im Einzelnen:
- FIG 1: ein Leistungsmodul mit einer Ausführungsform der beanspruchten Stützvorrichtung in einer Schrägansicht;
- FIG 2: eine erste Ausführungsform der beanspruchten Stützvorrichtung in einem Längsschnitt;
- FIG 3: eine zweite Ausführungsform der beanspruchten Stützvorrichtung in einer Schrägansicht;
- FIG 4: eine dritte Ausführungsform der beanspruchten Stützvorrichtung im unmontierten Zustand in Schrägansicht;
- FIG 5: die dritte Ausführungsform der beanspruchten Stützvorrichtung im montierten Zustand in Schrägansicht;
- FIG 6: die dritte Ausführungsform der beanspruchten Stützvorrichtung im montierten Zustand von schräg unten.

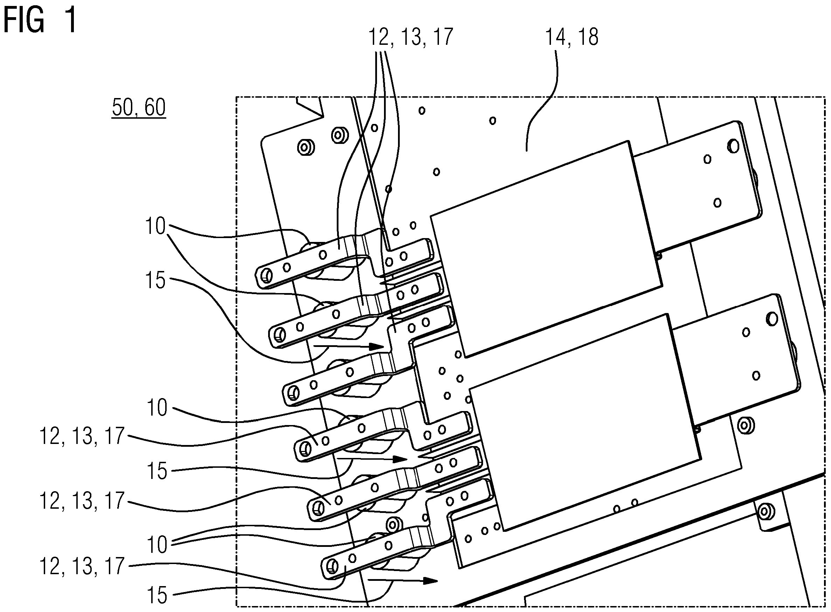

In FIG 1 ist eine Ausführungsform eines Leistungsmoduls 50 in einer Schrägansicht dargestellt, in dem zumindest eine erfindungsgemäße Stützvorrichtung 10 eingesetzt wird. Das Leistungsmodul 50 umfasst eine Mehrzahl an elektrisch leitenden Verbindungselementen 12, die jeweils als Stromschienen 17 ausgebildet sind. Die elektrisch leitenden Verbindungselemente 12 werden im Folgenden auch nur als Verbindungselemente 12 bezeichnet. Die Verbindungselemente 12 werden in einem aktiven Betriebszustand des Leistungsmoduls 50 erwärmt und sind dementsprechend zu entwärmen. Die Verbindungselemente 12 sind jeweils über eine Stützvorrichtung 10 mechanisch auf einer Gehäusekomponente 18 abgestützt, die als Wärmesenke 14 dient. Alternativ oder ergänzend kann auch ein nicht gezeigter Kühlkörper als Wärmesenke 14 dienen. Die Verbindungselemente 12 sind korrespondierend jeweils als Wärmequelle 13 aufzufassen. Im bestimmungsgemäßen Betrieb des Leistungsmoduls 50 liegt jeweils ein Wärmestrom 15 von den Verbindungselementen 12, also einer Wärmequelle 13, zur Wärmesenke 14 vor. Die Wärmeströme 15 durchfließen jeweils die zugehörigen Stützvorrichtungen 10. Zumindest eine der Stützvorrichtungen 10 ist gemäß einer der oben oder im Folgenden skizzierten Ausführungsformen ausgebildet. Das Betriebsverhalten der zumindest einen Stützvorrichtung 10, die nach einer der oben oder im Folgenden dargestellten Ausführungsformen ausgebildet ist, wird durch ein nicht näher abgebildetes Computerprogrammprodukt 60 simuliert. Das Computerprogrammprodukt 60 kann als sogenannter Digitaler Zwilling der entsprechenden Stützvorrichtung ausgebildet sein.

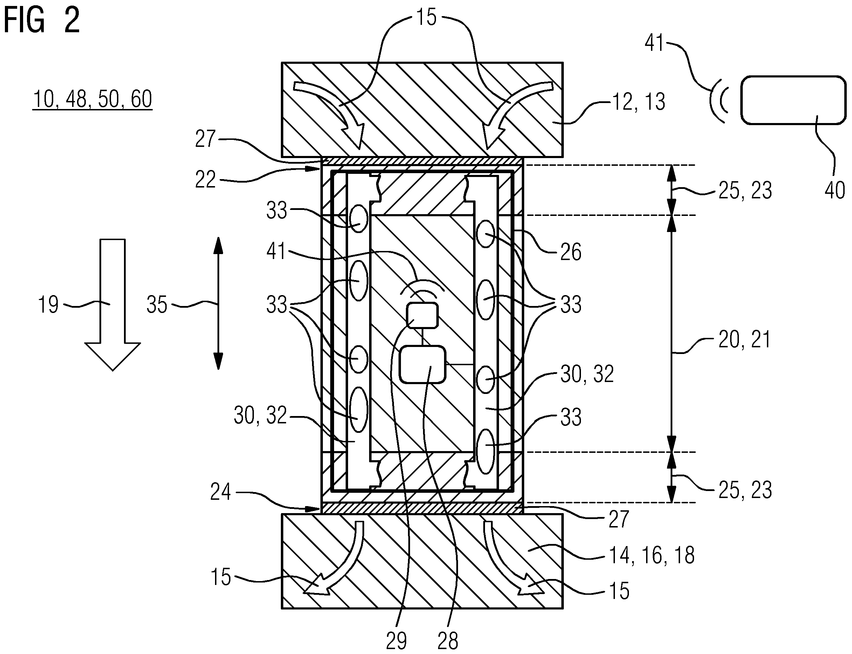

Eine erste Ausführungsform der beanspruchten Stützvorrichtung 10 ist in FIG 2 in einem Längsschnitt schematisch dargestellt. Die Stützvorrichtung 10 ist zwischen einem elektrisch leitenden Verbindungselement 12, das eine Wärmequelle 13 bildet, und einer Wärmesenke 14 angeordnet, die als Gehäusekomponente 18 oder als Kühlkörper 16 ausgebildet sein kann. Die Stützvorrichtung 10 ist einstückig ausgebildet und umfasst im einen mittleren Bereich 20, der zwischen je einem Endabschnitt 25 an einem verbindungselementseitigen Ende 22 und einem wärmesenkeseitigen Ende 24 liegt. Im mittleren Bereich 20 ist die Stützvorrichtung 10 aus einem ersten Werkstoff 21 hergestellt, der eine erste Wärmeleitfähigkeit aufweist. Im Bereich des verbindungselementseitigen Endes 22, als auch am entsprechenden Endabschnitt 25, ist die Stützvorrichtung 10 aus einem zweiten Werkstoff 23 hergestellt, der eine zweite Wärmeleitfähigkeit aufweist. Ebenso ist die Stützvorrichtung 10 im Bereich ihres wärmesenkeseitigen Endes 24, also im entsprechenden Endabschnitt 25, aus dem zweiten Werkstoff mit der zweiten Wärmeleitfähigkeit hergestellt. Die zweite Wärmeleitfähigkeit ist hierbei höher als die erste Wärmeleitfähigkeit. Der erste und zweite Werkstoff sind jeweils ein Kunststoff, der für eine Additive Fertigung geeignet ist und dem wärmeleitende Partikel in einstellbarer Form, also im Wesentlichen wählbarer Konzentration, beigemischt sind. Die unterschiedlichen Wärmeleitfähigkeiten im ersten und zweiten Werkstoff 21, 23 sind durch ein vorgebbares Einstellen jeweils einer Konzentration an wärmeleitenden Partikeln bei einem additiven Fertigen der Stützvorrichtung eingestellt. Ein Wärmestrom 15 aus der Wärmequelle 13 durchfließt am verbindungselementseitigen Ende 22 eine Wärmeleitpasteschicht 27 und tritt in den Endabschnitt 25 am verbindungselementseitigen Ende 22 in die Stützvorrichtung 10 ein.

Durch den am verbindungselementseitigen Ende 22 eintretenden Wärmestrom 15 erfolgt ein teilweises Verdampfen eines Fluids 32, das in einer Mehrzahl an pulsierenden Wärmerohren 30 aufgenommen ist. Die pulsierenden Wärmerohre 30 sind jeweils als Ausnehmungen innerhalb der Stützvorrichtung 10 ausgebildet und sind in einem Inneren der Stützvorrichtung 10 angeordnet. Dementsprechend sind die pulsierenden Wärmerohre 30 durch die Stützvorrichtung 10 selbst abgeschlossen. Dadurch, dass die zweite Wärmeleitfähigkeit im Endabschnitt 25 am verbindungselementseitigen Ende 22 höher ist als die erste Wärmeleitfähigkeit im mittleren Abschnitt 20 wird das Verdampfen des Fluids 32 unterstützt. In den pulsierenden Wärmerohren 30 bilden sich Dampfphasen 33, die sich als Blasen entlang des pulsierenden Wärmerohrs 30 bewegen. Im bestimmungsgemäßen Betrieb erfolgt ein Oszillieren 35 der Dampfphasen 33, so dass ein Wärmetransport zum wärmesenkeseitigen Ende 24 gewährleistet ist. Insgesamt erfolgt so eine Entwärmung 19 vom Verbindungselement 12 in die Wärmesenke 14. Korrespondierend zum eintretenden Wärmestrom 15 am verbindungselementseitigen Ende 22 tritt am wärmesenkeseitigen Ende 24 der Wärmestrom 15 aus den pulsierenden Wärmerohren 30 aus. Der Endabschnitt 25 am wärmesenkeseitigen Ende 24 ist aus dem zweiten Werkstoff 23 hergestellt, durch den eine Wärmeabgabe von den pulsierenden Wärmerohren 30 in den entsprechenden Endabschnitt 25 unterstützt wird. Der Wärmestrom 15, der von der Stützvorrichtung 10 in die Wärmesenke 14 eintritt, durchfließt eine Wärmeleitpasteschicht 27, die zwischen der Stützvorrichtung 10 und der Wärmesenke 14 angeordnet ist.

Das Fluid 32 weist gegenüber einer Umgebungsluft 48, in der die Stützvorrichtung 10 eingesetzt wird, einen Unterdruck auf. In der Stützvorrichtung 10 ist eine diffusionshemmende Beschichtung 26 ausgebildet, die ein Eindringen von Gasen oder Flüssigkeiten aus der Umgebungsluft 48 in die pulsierenden Wärmerohre 30 minimiert. Die diffusionshemmende Beschichtung 26 kann als metallische oder keramische Beschichtung ausgebildet sein. Die diffusionshemmende Beschichtung 26 ist auch durch Additive Fertigung herstellbar. Durch die pulsierenden Wärmerohre 30 wird eine leistungsfähige und selbstregulierende Entwärmung 19 des Verbindungselements 12 in die Wärmesenke 14 gewährleistet. Des Weiteren ist in der Stützvorrichtung 10 ein Sensor 28 angeordnet, der mit einem der pulsierenden Wärmerohre 30 gekoppelt ist. Der Sensor 28 ist dazu ausgebildet, eine physikalische Größe des pulsierenden Wärmerohrs 30 zu erfassen, beispielsweise eine Temperatur oder einen Druck des Fluids 32 im entsprechenden pulsierenden Wärmerohr 30. Der Sensor 28 ist mit einer Kommunikationseinheit 29 verbunden. Die Kommunikationseinheit 29 wiederum ist über eine kommunikative Datenverbindung 41, beispielsweise eine Drahtlosverbindung, mit einer übergeordneten Steuereinheit 40 verbunden. Die übergeordnete Steuereinheit 40 ist zu einem Überwachen der Entwärmung 19 ausgebildet und kann zum Leistungsmodul 50 gehören, in dem die Stützvorrichtung 10 eingesetzt ist. Weiter liegt ein nicht näher dargestelltes Computerprogrammprodukt 60 vor, das als sogenannter Digitaler Zwilling der Stützvorrichtung 10 ausgebildet ist. Das Computerprogrammprodukt 60 kann ein Abbild, insbesondere in digitales Abbild, der Stützvorrichtung 10 umfassen, und dazu ausgebildet sein, einen vorliegenden Betriebszustand der Stützvorrichtung 10 zu simulieren. Durch das Computerprogrammprodukt 60 sind vom Sensor 28 erfasste physikalische Größen überprüfbar, insbesondere plausibilisierbar. Das Computerprogrammprodukt 60 kann beispielsweise auf der übergeordneten Steuereinheit 40 ausführbar gespeichert sein.

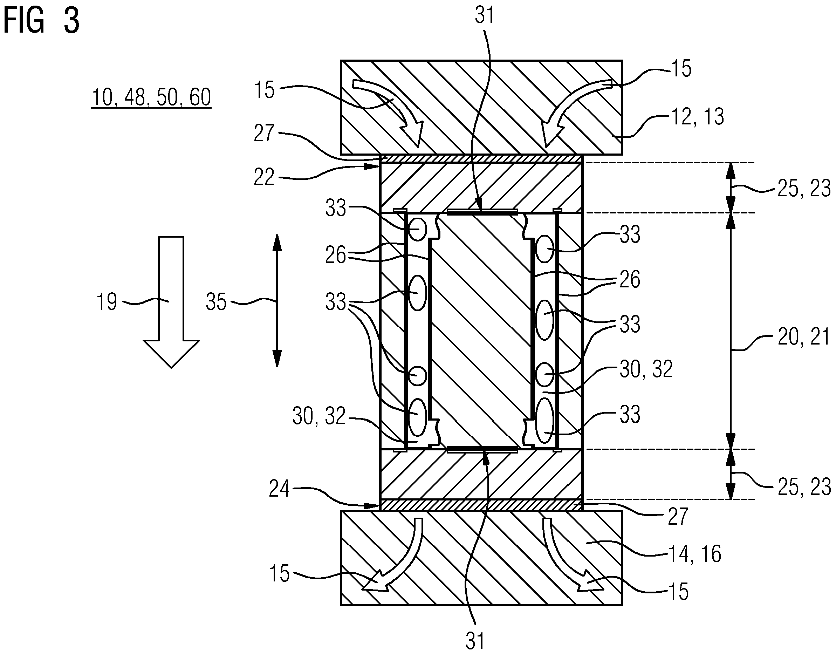

Eine zweite Ausführungsform der beanspruchten Stützvorrichtung 10 ist in FIG 3 schematisch in einem Längsschnitt dargestellt. Die Stützvorrichtung 10 ist zwischen einem elektrisch leitenden Verbindungselement 12, das eine Wärmequelle 13 bildet, und einer Wärmesenke 14 angeordnet, die als Gehäusekomponente 18 oder als Kühlkörper 16 ausgebildet sein kann. Die Stützvorrichtung 10 ist aus einer Mehrzahl an Komponenten hergestellt, die miteinander verbunden sind. Diese sind über stoffschlüssige Verbindungen 31 miteinander verbunden. Die Stützvorrichtung 10 umfasst einen mittleren Bereich 20, der zwischen je einem Endabschnitt 25 an einem verbindungselementseitigen Ende 22 und einem wärmesenkeseitigen Ende 24 liegt. Im mittleren Bereich 20 ist die Stützvorrichtung 10 aus einem ersten Werkstoff 21 hergestellt, der eine erste Wärmeleitfähigkeit aufweist. Der Endabschnitt 25 am verbindungselementseitigen Endes 22 ist aus einem zweiten Werkstoff 23 hergestellt, der eine zweite Wärmeleitfähigkeit aufweist. Ebenso ist die Stützvorrichtung 10 im Bereich ihres wärmesenkeseitigen Endes 24, also im entsprechenden Endabschnitt 25, aus dem zweiten Werkstoff mit der zweiten Wärmeleitfähigkeit hergestellt. Die zweite Wärmeleitfähigkeit ist hierbei höher als die erste Wärmeleitfähigkeit. Der erste und zweite Werkstoff sind jeweils ein Kunststoff, der für eine Additive Fertigung geeignet ist und dem wärmeleitende Partikel in einstellbarer Form, also im Wesentlichen wählbarer Konzentration, beigemischt sind. Die unterschiedlichen Wärmeleitfähigkeiten im ersten und zweiten Werkstoff 21, 23 sind durch ein vorgebbares Einstellen jeweils einer Konzentration an wärmeleitenden Partikeln bei einem additiven Fertigen der Stützvorrichtung eingestellt. Ein Wärmestrom 15 aus der Wärmequelle 13 durchfließt eine am verbindungselementseitigen Ende 22 eine Wärmeleitpasteschicht 27 und tritt in den Endabschnitt 25 am verbindungselementseitigen Ende 22 in die Stützvorrichtung 10 ein.

Durch den am verbindungselementseitigen Ende 22 eintretenden Wärmestrom 15 erfolgt ein teilweises Verdampfen eines Fluids 32, das in einer Mehrzahl an pulsierenden Wärmerohren 30 aufgenommen ist. Die pulsierenden Wärmerohre 30 sind jeweils als Ausnehmungen innerhalb der Stützvorrichtung 10 ausgebildet und sind in einem Inneren der Stützvorrichtung 10 angeordnet. Dementsprechend sind die pulsierenden Wärmerohre 30 durch die Endabschnitte 25 der Stützvorrichtung 10 abgeschlossen. Dadurch, dass die zweite Wärmeleitfähigkeit im Endabschnitt 25 am verbindungselementseitigen Ende 22 höher ist als die erste Wärmeleitfähigkeit im mittleren Abschnitt 20 wird das Verdampfen des Fluids 32 unterstützt. In den pulsierenden Wärmerohren 30 bilden sich Dampfphasen 33, die sich als Blasen entlang des pulsierenden Wärmerohrs 30 bewegen. Im bestimmungsgemäßen Betrieb erfolgt ein Oszillieren 35 der Dampfphasen 33, so dass ein Wärmetransport zum wärmesenkeseitigen Ende 24 gewährleistet ist. Insgesamt erfolgt so eine Entwärmung 19 vom Verbindungselement 12 in die Wärmesenke 14. Korrespondierend zum eintretenden Wärmestrom 15 am verbindungselementseitigen Ende 22 tritt am wärmesenkeseitigen Ende 24 der Wärmestrom 15 aus den pulsierenden Wärmerohren 30 aus. Der Endabschnitt 25 am wärmesenkeseitigen Ende 24 ist aus dem zweiten Werkstoff 23 hergestellt, durch den eine Wärmeabgabe von den pulsierenden Wärmerohren 30 in den entsprechenden Endabschnitt 25 unterstützt wird. Der Wärmestrom 15, der von der Stützvorrichtung 10 in die Wärmesenke 14 eintritt, durchfließt eine Wärmeleitpasteschicht 27, die zwischen der Stützvorrichtung 10 und der Wärmesenke 14 angeordnet ist.

Das Fluid 32 weist gegenüber einer Umgebungsluft 48, in der die Stützvorrichtung 10 eingesetzt wird, einen Unterdruck auf. In der Stützvorrichtung 10 ist eine diffusionshemmende Beschichtung 26 ausgebildet, die ein Eindringen von Gasen oder Flüssigkeiten aus der Umgebungsluft 48 in die pulsierenden Wärmerohre 30 minimiert. Die diffusionshemmende Beschichtung 26 kann als metallische oder keramische Beschichtung ausgebildet sein. Die diffusionshemmende Beschichtung 26 ist auch durch Additive Fertigung herstellbar. Durch die pulsierenden Wärmerohre 30 wird eine leistungsfähige und selbstregulierende Entwärmung 19 des Verbindungselements 12 in die Wärmesenke 14 gewährleistet. Die diffusionshemmende Beschichtung 26 ist in den Ausnehmungen angebracht, also an Innenflächen der pulsierenden Wärmerohre 30. Hierdurch ist der mittlere Bereich 20 als schützende Absorptionsstrecke nutzbar, die Fluide, beispielsweise Gase, aus der Umgebungsluft 48 absorbiert und so deren Eindringen in die pulsierenden Wärmerohre 30 minimiert bzw. verhindert. Ebenso sind diffusionshemmende Beschichtungen 26 im Bereich einer Grenze zwischen dem mittleren Bereich 20 und den Endabschnitten 35 angebracht. Diese sind dazu ausgebildet, ein Eindringen von Fluid aus der Umgebungsluft 48 über die Endabschnitte 25 am verbindungselementseitigen Ende 22 bzw. am wärmesenkeseitigen Ende 24 zu minimieren. Weiter liegt ein nicht näher dargestelltes Computerprogrammprodukt 60 vor, das als sogenannter Digitaler Zwilling der Stützvorrichtung 10 ausgebildet ist. Das Computerprogrammprodukt 60 kann ein Abbild, insbesondere in digitales Abbild, der Stützvorrichtung 10 umfassen, und dazu ausgebildet sein, einen vorliegenden Betriebszustand der Stützvorrichtung 10 zu simulieren.

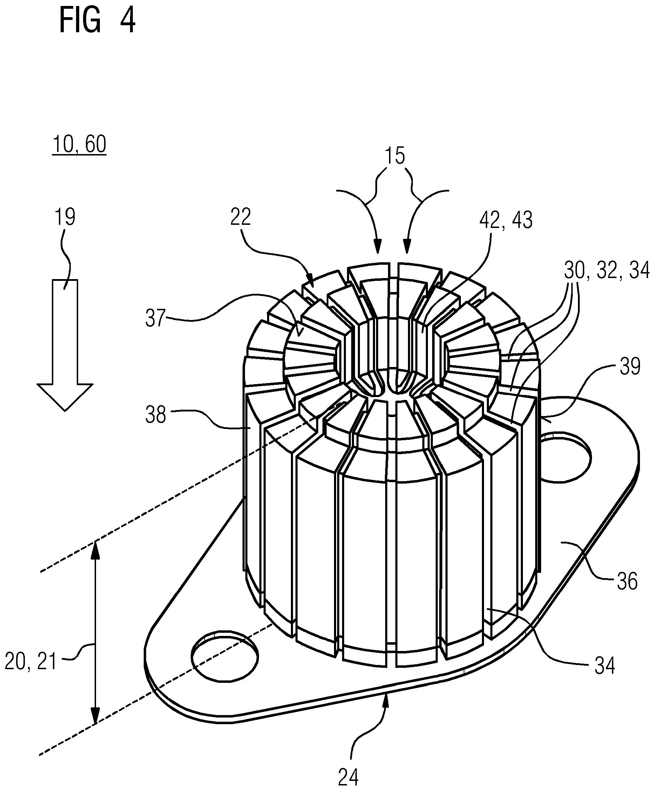

Eine dritte Ausführungsform der beanspruchten Stützvorrichtung 10 ist in FIG 4 in einem unmontierten Zustand in einer Schrägansicht dargestellt. Die Stützvorrichtung 10 umfasst einen Kernabschnitt 38, der im Wesentlichen zylinderförmig ausgebildet ist und an seiner Umfangswandung 39, die als Zylindermantelfläche ausgebildet ist, an der wiederum eine Mehrzahl an Ausnehmungen 34 ausgebildet ist. Die Ausnehmungen 34 bilden in einem montierten Zustand die pulsierenden Wärmerohre 30, in denen ein Fluid 32 aufgenommen ist, durch das eine angestrebte Entwärmung 19 erfolgt. Die Ausnehmungen 34 erstrecken sich in einem mittleren Bereich 20 von einem wärmesenkeseitigen Ende 24 zu einem verbindungselementseitigen Ende 22. Im unmontierten Zustand bilden die Ausnehmungen 34 im Wesentlichen offene Rinnen. Der Kernabschnitt 38 ist aus einem ersten Werkstoff 21 hergestellt, der als Kunststoff ausgebildet ist. Am verbindungselementseitigen Ende 22 weist der Kernabschnitt 38 eine Stirnfläche 37 auf, an der sich die Ausnehmungen 34 fortsetzen. Die Ausnehmungen 34 sind an der Stirnfläche 37 im Wesentlichen sternförmig ausgebildet. An der Stirnfläche 37 ist eine im Wesentlichen mittige Ausnehmung ausgebildet, durch die eine eingestülpte Fläche 42 ausgebildet ist. Die Ausnehmungen 34, die im montierten Zustand die pulsierenden Wärmerohre 30 bilden, erstrecken sich auch entlang der eingestülpten Fläche 42. Die eingestülpte Fläche 42 ist umlaufend ausgebildet und dient im montierten Zustand zu einer Wärmeankopplung 43 des Kernabschnitts 38, also im Bereich des verbindungselementseitigen Endes 22 der Stützvorrichtung 10. Durch die eingestülpte Fläche 42 wird eine vergrößerte Oberfläche für einen Wärmestrom 15 bereitgestellt, der von einem nicht näher gezeigten Verbindungselement 12 zu einer nicht näher gezeigten Wärmesenke 14, also dem Kühlkörper 16 bzw. der Gehäusekomponente 18, über die pulsierende Wärmerohre 30 zu transportieren ist. Der Kernabschnitt 38 kann ferner als Hohlkörper ausgebildet sein, wodurch eine Herstellung mittels Spritzgießen vereinfacht ist.

Am wärmesenkeseitigen Ende 24 ist die Stützvorrichtung 10 mit einem Montagefuß 36 versehen, über den die Stützvorrichtung 10 mit der Wärmesenke 14 koppelbar ist. Das Koppeln mit der Wärmesenke 14 umfasst ein mechanisches Ankoppeln und ein thermisches Ankoppeln. Weiter liegt ein nicht näher dargestelltes Computerprogrammprodukt 60 vor, das als sogenannter Digitaler Zwilling der Stützvorrichtung 10 ausgebildet ist. Das Computerprogrammprodukt 60 kann ein Abbild, insbesondere in digitales Abbild, der Stützvorrichtung 10 umfassen, und dazu ausgebildet sein, einen vorliegenden Betriebszustand der Stützvorrichtung 10 zu simulieren.

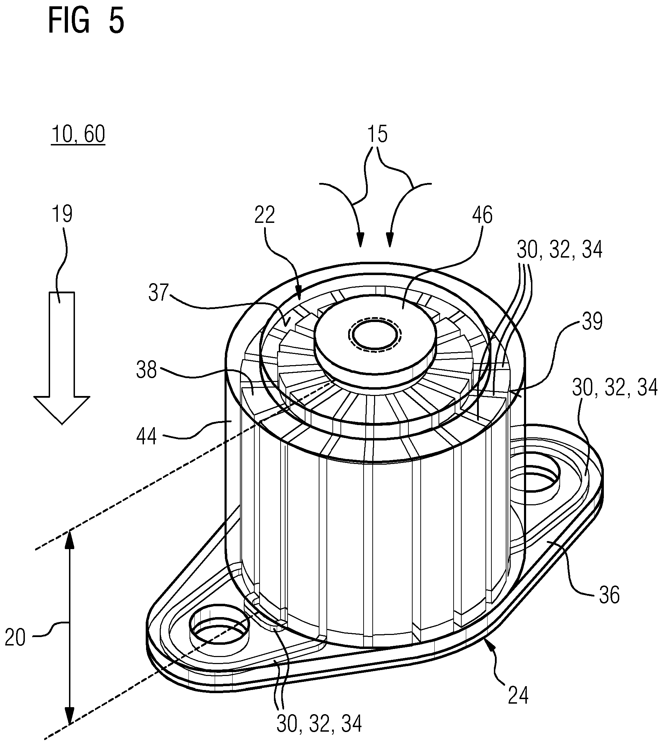

Die dritte Ausführungsform der beanspruchten Stützvorrichtung 10, wie in FIG 4 gezeigt, ist in FIG 5 in einem montierten Zustand in Schrägansicht gezeigt. Die Beschreibungen zu FIG 4 gelten analog auch für FIG 5 fort. In FIG 5 ist der Kernabschnitt 38 mit einem Glockenabschnitt 44 verbunden, der dem Kernabschnitt 38 im Wesentlichen übergestülpt ist. Zur besseren Übersicht ist der Glockenabschnitt 44 in FIG 5 transparent dargestellt. Der Glockenabschnitt 44 ist im Wesentlichen als einseitig abgeschlossener und einseitige offener Hohlzylinder ausgebildet. Die Ausnehmungen 34 am Kernabschnitt 38, die im unmontierten Zustand Rinnen bilden, werden durch den Glockenabschnitt 44 zumindest im mittleren Bereich 20 verschlossen und sind dadurch geeignet, das Fluid 32 aufzunehmen, durch das die Funktionalität der pulsierenden Wärmerohre 30 erzielt wird. Auch an Glockenabschnitt 44 ist ein Montagefuß 36 angeformt, dessen Form mit dem Montagefuß 36 des Kernabschnitts 38 korrespondiert. Alternativ kann der Montagefuß 36 auch als separate Komponente ausgebildet sein, die bei der Herstellung der Stützvorrichtung 10 mit dem Kernabschnitt 38 verbunden wird. Im Montagefuß 36 des Glockenabschnitts 44 sind Ausnehmungen 34 ausgebildet, die sich durch den Montagefuß 36 erstrecken. Die Ausnehmungen 34 im Montagefuß 36 des Glockenabschnitts 44 sind mit Ausnehmungen 34 am Kernabschnitt 38 verbunden, so dass diese ebenfalls mit Fluid 32 teilweise gefüllt sind. Dementsprechend sind durch die Ausnehmungen 34 im Montagefuß 36 des Glockenabschnitts 44 auch pulsierende Wärmerohre 30 ausgebildet. Durch die vergrößerte Oberfläche des Montagefußes 36 am Kernabschnitt 38 bzw. am Glockenabschnitt 44 wird eine verbesserte thermische Ankopplung der Stützvorrichtung 10 an die nicht näher gezeigte Wärmesenke 14 erzielt. Der Kernabschnitt 38 und/oder der Glockenabschnitt 44 können durch Additive Fertigung hergestellt sein, so dass ein erhöhter Anteil deren Montagefüße 36 für pulsierende Wärmerohre 30, und damit zur angestrebten Entwärmung 19, nutzbar ist. Infolgedessen ist die beanspruchte Stützvorrichtung 10 thermisch besser ausnutzbar. Dadurch, dass das Fluid 32 über den Montagefuß 36 elektrisch vom Verbindungselement 12 isoliert ist, kann das Fluid 32 selbst elektrisch leitend ausgebildet sein.

Der Kernabschnitt 38 wird auch im Bereich dessen Stirnfläche 37 bedeckt und so die Ausnehmungen 34, die im unmontierten Zustand offene Rinnen bilden, abgeschlossen. Am verbindungselementseitigen Ende 22 ist am Glockenabschnitt 44 ein Einkopplungselement 46 angeordnet, das aus einem metallischen Werkstoff hergestellt ist. Das Einkopplungselement 46 ist dazu ausgebildet, das nicht näher gezeigte Verbindungselement 12 zu kontaktieren und so einen Wärmestrom 15 in die Stützvorrichtung 10 einzuleiten. Der Glockenabschnitt 44 weist im Bereich der eingestülpten Fläche 42, wie in FIG 4 dargestellt, mit einer Ausnehmung versehen, in der das Einkopplungselement 46 aufgenommen ist. Da das Einkopplungselement 46 aus einem metallischen Werkstoff hergestellt ist, weist dieses gegenüber dem ersten Werkstoff 21, auf dem der mittlere Bereich 20 des Kernabschnitts 38 hergestellt ist, eine gesteigerte Wärmeleitfähigkeit auf. Durch die an der eingestülpten Fläche 42 vorliegende vergrößerte Oberfläche ist somit ein erhöhter Wärmestrom 15 in die pulsierenden Wärmerohre 15 einleitbar. Der Kernabschnitt 38 und der Glockenabschnitt 44 sind in einfacher Weise, beispielsweise durch Additive Fertigung oder Spritzgießen, herstellbar und bieten eine gesteigerte Kapazität zur Entwärmung 19 des Verbindungselements 12. Dementsprechend wird die Funktionsintegration aus mechanischem Abstützen und Entwärmen in besonders kosteneffizienter Weise verwirklicht. Weiter liegt ein nicht näher dargestelltes Computerprogrammprodukt 60 vor, das als sogenannter Digitaler Zwilling der Stützvorrichtung 10 ausgebildet ist. Das Computerprogrammprodukt 60 kann ein Abbild, insbesondere in digitales Abbild, der Stützvorrichtung 10 umfassen, und dazu ausgebildet sein, einen vorliegenden Betriebszustand der Stützvorrichtung 10 zu simulieren.

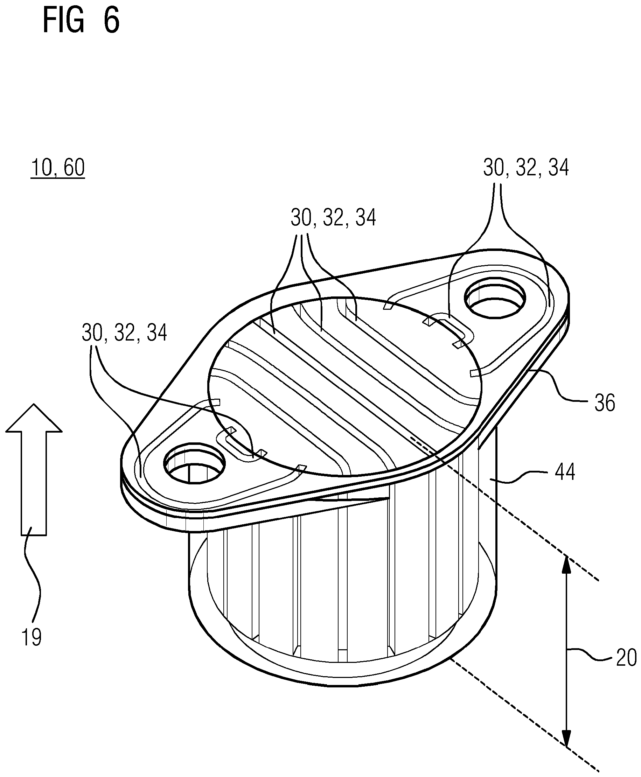

Weiter ist die dritte Ausführungsform der beanspruchten Stützvorrichtung 10 in FIG 6 im montierten Zustand in einer Schrägansicht von unten gezeigt. Zur besseren Übersicht ist der Montagefuß 36 des Kernabschnitt 38 transparent dargestellt. Im Bereich des Montagefußes 36 sind im Kernabschnitt 38 Ausnehmungen 34 ausgebildet, die Ausnehmungen 34 an der Umfangswandung 39 des Kernabschnitts 38 miteinander verbindet. Weiter sind im Bereich des Montagefußes 36 des Glockenabschnitts 44 Ausnehmungen 34 ausgebildet, die schlaufenförmig Ausnehmungen 34 an der Umfangswandung 39 des Kernabschnitts 38 verbinden. Dadurch werden im Montagefuß 36 pulsierende Wärmerohre 30 ausgebildet, durch die wiederum die Oberfläche des Montagefußes 36 des Kernabschnitts 38 zur Entwärmung 19 ausgenutzt wird. Weiter liegt ein nicht näher dargestelltes Computerprogrammprodukt 60 vor, das als sogenannter Digitaler Zwilling der Stützvorrichtung 10 ausgebildet ist. Das Computerprogrammprodukt 60 kann ein Abbild, insbesondere in digitales Abbild, der Stützvorrichtung 10 umfassen, und dazu ausgebildet sein, einen vorliegenden Betriebszustand der Stützvorrichtung 10 zu simulieren.

## Patentansprüche

1. Stützvorrichtung (10) zum mechanischen Abstützen eines elektrisch leitenden zu entwärmenden Verbindungselements (12) auf einer Wärmesenke (14), die das Verbindungselement (12) von der Wärmesenke (14) elektrisch isoliert, wobei in der Stützvorrichtung (10) zu einer Entwärmung des Verbindungselements (12) in die Wärmesenke (14) zumindest ein pulsierendes Wärmerohr (30) ausgebildet ist, **dadurch gekennzeichnet, dass** das zumindest eine pulsierende Wärmerohr (30) zumindest teilweise mit einer diffusionshemmenden Beschichtung (26) versehen ist.

2. Stützvorrichtung (10) nach Anspruch 1, **dadurch gekennzeichnet, dass** die Stützvorrichtung (10) in einem mittleren Bereich (20) aus einem ersten Werkstoff (21) mit einer ersten Wärmeleitfähigkeit ausgebildet ist und an einem verbindungselementseitigen Ende (22) und/oder einem wärmesenkeseitigen Ende (24) aus einem zweiten Werkstoff (23) mit einer zweiten Wärmeleitfähigkeit hergestellt ist.

3. Stützvorrichtung (10) nach Anspruch 1 oder 2, **dadurch gekennzeichnet, dass** am verbindungselemmentseitigen Ende (22) ein Montagefuß (36) ausgebildet ist, durch den sich das zumindest eine pulsierende Wärmerohr (30) erstreckt.

4. Stützvorrichtung (10) nach einem der Ansprüche 1 bis 3, **dadurch gekennzeichnet, dass** das zumindest eine pulsierende Wärmerohr (30) zumindest teilweise mit einem elektrisch leitenden Fluid (32) gefüllt ist.

5. Stützvorrichtung (10) nach einem der Ansprüche 1 bis 4, **dadurch gekennzeichnet, dass** die Stützvorrichtung (10) einstückig ausgebildet ist oder einen Kernabschnitt (38) aufweist, auf dem ein Glockenabschnitt (44) befestigt ist.

6. Stützvorrichtung (10) nach einem der Ansprüche 1 bis 5, **dadurch gekennzeichnet, dass** eine Mehrzahl an pulsierenden Wärmerohren (30) im Bereich einer Umfangswandung (39) ausgebildet ist, zwischen dem verbindungselementseitigen Ende (22) und dem wärmesenkeseitigen Ende (24) liegt.

7. Stützvorrichtung (10) nach einem der Ansprüche 1 bis 6, **dadurch gekennzeichnet, dass** die diffusionshemmende Beschichtung (26) durch Gasphasenabscheidung, physikalische Dampfabscheidung, einen Sol-Gel-Prozess, thermisches Sprühen, durch Bedampfen, autokatalytisches Beschichten oder durch ein Galvanik-Verfahren hergestellt ist.

8. Stützvorrichtung (10) nach einem der Ansprüche 6 oder 7, **dadurch gekennzeichnet, dass** die Umfangswandung (39), das verbindungselementseitige Ende (22) und/oder das wärmesenkeseitige Ende (24) der Stützvorrichtung (10) an deren Oberfläche oder in deren Inneren mit einer diffusionshemmenden Beschichtung (26) versehen ist.

9. Stützvorrichtung (10) nach einem der Ansprüche 1 bis 8, **dadurch gekennzeichnet, dass** das zumindest eine pulsierende Wärmerohr (30) durch die Wärmesenke (14) und/oder das Verbindungselement (12) verschlossen ist.

10. Stützvorrichtung (10) nach einem der Ansprüche 1 bis 9, **dadurch gekennzeichnet, dass** die Stützvorrichtung (10) einen Sensor (28) zum Erfassen einer physikalischen Größe des zumindest einen pulsierende Wärmerohrs (30) und/oder einer Komponente der Stützvorrichtung (10) aufweist.

11. Stützvorrichtung (10) nach einem der Ansprüche 1 bis 10, **dadurch gekennzeichnet dass** die Stützvorrichtung (10) am verbindungselementseitigen Ende (22) und/oder am wärmesenkeseitigen Ende (24) eine Ausnehmung aufweist, durch die eine eingestülpte Fläche (42) eine Wärmeankopplung (43) an das zu entwärmende Verbindungselement (12) bzw. die Wärmesenke (14) bereitstellt.

12. Stützvorrichtung (10) nach Anspruch 11, **dadurch gekennzeichnet, dass** in der Ausnehmung, die die eingestülpte Fläche (42) zur Wärmeankopplung (43) bildet, ein Einkopplungselement (46) aus einem metallischen Werkstoff aufgenommen ist.

13. Stützvorrichtung (10) nach einem der Ansprüche 1 bis 12, **dadurch gekennzeichnet, dass** die Stützvorrichtung (10) zumindest teilweise durch ein additives Fertigungsverfahren hergestellt ist.

14. Leistungsmodul (50), umfassend ein Substrat mit mindestens einem zu entwärmenden elektrisch leitenden Verbindungselement (12), wobei das Verbindungselement (12) auf einer Wärmesenke (14) durch eine Stützvorrichtung (10) abgestützt montiert ist, **dadurch gekennzeichnet, dass** die Stützvorrichtung (10) nach einem der Ansprüche 1 bis 13 ausgebildet ist.

15. Computerprogrammprodukt (60), umfassend Befehle, die bei der Ausführung des Computerprogrammprodukts (60) durch einen Computer diesen veranlassen, ein Betriebsverhalten einer Stützvorrichtung (10) nach einem der Ansprüche 1 bis 13 zu simulieren.

## Claims

1. Supporting device (10), which serves for mechanically supporting on a heat sink (14) an electrically conductive connection element (12) from which heat is to be dissipated and which electrically insulates the connection element (12) from the heat sink (14), wherein at least one pulsating heat pipe (30) is formed in the supporting device (10) for the purpose of dissipating heat from the connection element (12) into the heat sink (14), **characterized in that** the at least one pulsating heat pipe (30) is at least partially provided with a diffusion-inhibiting coating (26).

2. Supporting device (10) according to Claim 1, **characterized in that** the supporting device (10) is formed in the middle region (20) from a first material (21) with a first thermal conductivity and is formed at an end (22) on the connection element side and/or an end (24) on the heat sink side from a second material (23) with a second thermal conductivity.

3. Supporting device (10) according to Claim 1 or 2, **characterized in that** a mounting foot (36), through which the at least one pulsating heat pipe (30) extends, is formed at the end (22) on the connection element side.

4. Supporting device (10) according to one of Claims 1 to 3, **characterized in that** the at least one pulsating heat pipe (30) is at least partially filled with an electrically conductive fluid (32).

5. Supporting device (10) according to one of Claims 1 to 4, **characterized in that** the supporting device (10) is formed in one piece or has a core portion (38) on which a bell portion (44) is fastened.

6. Supporting device (10) according to one of Claims 1 to 5, **characterized in that** a plurality of pulsating heat pipes (30) are formed in the region of a circumferential wall (39), lying between the end (22) on the connection element side and the end (24) on the heat sink side.

7. Supporting device (10) according to one of Claims 1 to 6, **characterized in that** the diffusion-inhibiting coating (26) is produced by vapour phase deposition, physical vapour deposition, a sol-gel process, thermal spraying, vapour coating, autocatalytic coating or by an electroplating process.

8. Supporting device (10) according to either of Claims 6 and 7, **characterized in that** the circumferential wall (39), the end (22) on the connection element side and/or the end (24) on the heat sink side of the supporting device (10) is provided on its surface or inside with a diffusion-inhibiting coating (26).

9. Supporting device (10) according to one of Claims 1 to 8, **characterized in that** the at least one pulsating heat pipe (30) is closed by the heat sink (14) and/or the connection element (12).

10. Supporting device (10) according to one of Claims 1 to 9, **characterized in that** the supporting device (10) has a sensor (28) for sensing a physical variable of the at least one pulsating heat pipe (30) and/or of a component of the supporting device (10).

11. Supporting device (10) according to one of Claims 1 to 10, **characterized in that** the supporting device (10) has at the end (22) on the connection element side and/or at the end (24) on the heat sink side a recess by which an invaginated surface (42) provides a thermal coupling (43) to the connection element (12) from which heat is to be dissipated or to the heat sink (14).

12. Supporting device (10) according to Claim 11, **characterized in that** a coupling-in element (46) of a metal material is held in the recess which forms the invaginated surface (42) for the thermal coupling (43).

13. Supporting device (10) according to one of Claims 1 to 12, **characterized in that** the supporting device (10) is at least partially produced by an additive manufacturing process.

14. Power module (50), comprising a substrate with at least one electrically conductive connection element (12) from which heat is to be dissipated, wherein the connection element (12) is mounted such that it is supported on a heat sink (14) by a supporting device (10), **characterized in that** the supporting device (10) is formed according to one of Claims 1 to 13.

15. Computer program product (60), comprising commands which, when the computer program product (60) is executed by a computer, cause the computer to simulate operating behaviour of a supporting device (10) according to one of Claims 1 to 13.

## Revendications

1. Dispositif (10) de support pour supporter mécaniquement sur un puits (14) de chaleur un élément (12) de liaison conducteur de l'électricité dont on doit dissiper de la chaleur, dispositif qui isole électriquement l'élément (12) de liaison du puits (14) de chaleur, dans lequel, dans le dispositif (10) de support, il est constitué, pour dissiper de la chaleur de l'élément (12) de liaison dans le puits (14) de chaleur, au moins un caloduc (30) pulsé, **caractérisé en ce que** le au moins un caloduc (30) pulsé est pourvu au moins en partie d'un revêtement (26) empêchant la diffusion.

2. Dispositif (10) de support suivant la revendication 1, **caractérisé en ce que** le dispositif (10) de support est, dans une partie (20) médiane, en un premier matériau (21) ayant une première conductivité de la chaleur et est fabriqué, à une extrémité (22) du côté de l'élément de liaison et/ou à une extrémité (24) du coté du puits de chaleur, en un deuxième matériau (23) ayant une deuxième conductivité de la chaleur.

3. Dispositif (10) de support suivant l'une des revendications 1 ou 2, **caractérisé en ce que**, à l'extrémité (22) du côté de l'élément de liaison, est constitué un pied (36) de montage, dans lequel s'étend au moins un caloduc (30) pulsé.

4. Dispositif (10) de support suivant l'une des revendications 1 à 3, **caractérisé en ce que** le au moins un caloduc (30) pulsé est rempli au moins en partie d'un fluide (32) conducteur de l'électricité.

5. Dispositif (10) de support suivant l'une des revendications 1 à 4, **caractérisé en ce que** le dispositif (10) de support est constitué d'une seule pièce ou a une partie (38) formant noyau, sur laquelle est fixée une partie (44) en cloche.

6. Dispositif (10) de support suivant l'une des revendications 1 à 5, **caractérisé en ce qu'**une pluralité de caloducs (30) pulsés, constitués dans la partie d'une paroi (39) périphérique, se trouve entre l'extrémité (22) du côté de l'élément de liaison et l'extrémité (24) du côté du puits de chaleur.

7. Dispositif (10) de support suivant l'une des revendications 1 à 6, **caractérisé en ce que** le revêtement (26) empêchant la diffusion est fabriqué par dépôt en phase gazeuse, par dépôt en phase vapeur physique, par un procédé sol-gel, par pulvérisation thermique, par évaporation, par revêtement autocatalytique ou par un procédé galvanique.

8. Dispositif (10) de support suivant l'une des revendications 6 ou 7, **caractérisé en ce que** la paroi (39) périphérique, l'extrémité (22) du côté de l'élément de liaison et/ou l'extrémité (24) du côté du puits de chaleur du dispositif (10) de support est pourvue d'un revêtement (26) empêchant la diffusion sur sa surface supérieure ou à l'intérieur.

9. Dispositif (10) de support suivant l'une des revendications 1 à 8, **caractérisé en ce que** le au moins un caloduc (30) pulsé est fermé par le puits (14) de chaleur et/ou par l'élément (12) de liaison.

10. Dispositif (10) de support suivant l'une des revendications 1 à 9, **caractérisé en ce que** le dispositif (10) de support a un capteur (28) de détection d'une grandeur physique du au moins un caloduc (30) pulsé et/ou d'un élément du dispositif (10) de support.

11. Dispositif (10) de support suivant l'une des revendications 1 à 10, **caractérisé en ce que** le dispositif (10) de support a, à l'extrémité (22) du côté de l'élément de liaison et/ou à l'extrémité (24) du côté du puits de chaleur, un évidement par lequel une surface (42) retournée donne un couplage (43) calorifique avec l'élément (12) de liaison dont on doit dissiper la chaleur ou avec le puits (14) de chaleur.

12. Dispositif (10) de support suivant la revendication 11, **caractérisé en ce que**, dans l'évidement, qui forme la surface (42) retournée pour le couplage (43) calorifique, est logé un élément (46) de couplage en un matériau métallique.

13. Dispositif (10) de support suivant l'une des revendications 1 à 12, **caractérisé en ce que** le dispositif (10) de support est fabriqué au moins en partie par un procédé de fabrication additif.

14. Module (50) de puissance, comprenant un substrat ayant au moins un élément (12) de liaison conducteur de l'électricité dont on doit dissiper de la chaleur, dans lequel l'élément (12) de liaison est monté supporté sur un puits (14) de chaleur par un dispositif (10) de support, **caractérisé en ce que** le dispositif (10) de support est constitué suivant l'une des revendications 1 à 13.

15. Produit (60) de programme d'ordinateur, comprenant des instructions qui, lors de l'exécution du produit (60) de programme d'ordinateur par un ordinateur, font qu'elles simulent un procédé de fonctionnement d'un dispositif (10) de support suivant l'une des revendications 1 à 13.
